Europäisches Patentamt

(19) European Patent Office

Office européen des brevets

(11) Numéro de publication: **0 1 1 4 765**
**B1**

(12) **FASCICULE DE BREVET EUROPEEN**

(45) Date de publication du fascicule du brevet:
**19.11.87**

(21) Numéro de dépôt: **84400078.6**

(22) Date de dépôt: **13.01.84**

(51) Int. Cl.⁴: **G 01 N 23/225,** H 01 J 37/02, H 01 J 37/252

(54) **Procédé et dispositif pour l'analyse ionique d'un échantillon isolant.**

(30) Priorité: **14.01.83 FR 8300538**

(43) Date de publication de la demande:
**01.08.84 Bulletin 84/31**

(45) Mention de la délivrance du brevet:
**19.11.87 Bulletin 87/47**

(84) Etats contractants désignés:
**DE GB**

(56) Documents cités:
**FR - A - 2 111 481**
**GB - A - 918 297**

**JAPANESE JOURNAL OF APPLIED PHYSICS, vol. 16, no. 8, août 1977, pages 1307-1311, Tokyo, JP; K.NAKAMURA et al: "Detection of SiO2 ions from SiO2-Si interface by means of SIMS"**

(73) Titulaire: **CAMECA, 103, Boulevard Saint-Denis, F-92400 Courbevoie (FR)**

(72) Inventeur: **Siodzian, Georges, THOMSON-CSF SCPI 173, bld Haussmann, F-75379 Paris Cedex 08 (FR)**
Inventeur: **Chaintreau, Marcel, THOMSON-CSF SCPI 173, bld Haussmann, F-75379 Paris Cedex 08 (FR)**
Inventeur: **Dennebouy, Roger, THOMSON-CSF SCPI 173, bld Haussmann, F-75379 Paris Cedex 08 (FR)**

(74) Mandataire: **Turlèque, Clotilde et al, THOMSON-CSF SCPI 19, avenue de Messine, F-75008 Paris (FR)**

ACTORUM AG

## Description

L'invention concerne un procédé et un dispositif permettant l'analyse ionique d'un échantillon isolant.

De façon classique en spectroscopie, on bombarde par un faisceau d'ions primaires une cible à la surface de l'échantillon à analyser. La cible émet alors des ions négatifs qui sont recueillis par un système qui donne la carte de distribution des éléments présents à la surface de l'échantillon.

L'article intitulé «Detection of $SiO_2$ ions from $SiO_2$-Si interface by means of SIMS" tiré de Japanese Journal of Applied Physics Vol 16, n° 8 août 1977 décrit un spectromètre de masse de structure habituelle, dans lequel le voisinage de la cible est un espace sans champ électrique.

Cette technique est satisfaisante pour des échantillons suffisamment conducteurs.

Mais, un grand nombre d'échantillons soumis à l'analyseur ionique sont isolants: sections polies de roches, coupes de dents ou d'os, coupes de tissus biologiques, inclusions d'oxydes, couches d'oxydes, couches de passivation... L'observation de ces échantillons pose des problèmes parce que les charges électriques s'écoulent mal. Même lorsqu'un équilibre est atteint entre les flux de charges reçues, émises ou évacuées par une faible conductivité, des excès ou défauts de charges peuvent exister localement et créer des potentiels qui décalent les distributions en énergie des ions secondaires, déforment les trajectoires des ions secondaires qui vont former les images et modifient les conditions de bombardement primaire. En outre, les champs électriques peuvent être localement très intenses et induire la migration d'un certain nombre d'éléments. Ce phénomène est particulièrement visible lorsqu'on fait le relevé des profils d'implantation ou de diffusion dans des couches de silices sur les semiconducteurs.

Ce problème a été partiellement résolu dans le cas où l'on extrait des ions positifs émis par la cible: une grille métallique est déposée par évaporation sur la surface. Les plages isolantes de l'échantillon reçoivent, en plus du faisceau d'ions primaires, des électrons secondaires de faible énergie émis par les barreaux de la grille et des électrons de haute énergie produits sur l'électrode d'extraction et attirés par l'échantillon. Le contrôle du potentiel de surface de l'échantillon est alors obtenu en ajustant convenablement la densité du bombardement primaire.

En revanche, lorsqu'on s'intéresse aux ions secondaires négatifs, d'une part, les électrons produits sur l'électrode d'extraction sont repoussés par l'échantillon et, d'autre part, le champ électrostatique extrait en même temps les électrons secondaires émis par la cible: l'émission d'électrons secondaires est bien plus intense que l'émission ionique, si bien que, quel que soit le signe des ions primaires de bombardement, il apparaît toujours une charge positive à la surface. Cette émission est encore accrue lorsqu'on abaisse le travail de sortie par un bombardement $CS^+$, $K^+$ ou un soufflage de vapeurs de Cs. De plus, sur des échantillons hétérogènes, cette charge peut varier d'un endroit à l'autre en fonction du rendement en électrons secondaires du lieu considéré. L'expérience montre que cette charge positive est telle que toute microscopie ionique à partir d'ions secondaires négatifs est impossible avec les procédés traditionnels.

Le brevet français n° 2 111 481 décrit un procédé pour neutraliser les charges créées par le bombardement ionique d'un échantillon isolant, utilisant un faisceau d'électrons créé au voisinage de la cible, de vitesse faible, des moyens de réglage de l'intensité du faisceau étant prévus pour l'ajuster aux charges à compenser.

Un tel procédé est compliqué, encombre la zone d'extraction au voisinage de la cible et nécessite des réglages délicats.

L'invention a pour objet un procédé de neutralisation, dans un système où l'extraction a lieu sous champ élevé, qui permet d'éviter les inconvénients mentionnés ci-dessus.

Suivant l'invention un procédé d'analyse ionique d'un échantillon isolant, porté à un fort potentiel négatif déterminé, du type selon lequel on bombarde une cible sur la surface de l'échantillon à analyser par un faisceau d'ions primaires, est caractérisé en ce que les ions négatifs émis par la cible bombardée sont utilisés pour produire une image ionique de l'échantillon, ces ions étant extraits sous champ élevé au moyen d'une électrode extractrice portée au potentiel nul, le procédé étant tel que la neutralisation des charges apparaissant à la surface de l'échantillon est effectuée par un faisceau d'électrons émis par un filament généré en dehors de la zone d'extraction des ions émis par la cible, et accéléré sous un champ égal au champ d'extraction au voisinage de la cible, puis dirigé orthogonalement à la cible avant d'entrer dans le voisinage de la cible où il est ralenti par le même champ élevé de sens contraire, la composante normale de la vitesse s'annulant ainsi juste au niveau de la surface de la cible.

L'invention propose également un dispositif pour l'analyse ionique d'un échantillon isolant porté à un potentiel négatif prédéterminé, du type qui comporte une source d'ions de bombardement primaire dirigé sur une cible à la surface de l'échantillon à analyser, et, dans l'axe optique du dispositif, un spectrographe de masse.

L'invention sera mieux comprise et d'autres caractéristiques apparaîtront à la lecture de la description non limitative d'un mode préféré de réalisation, faite en se référant aux planches en annexe sur lesquelles:

– la figure 1 est un schéma du dispositif d'analyse ionique conforme à l'invention.

– les figures 2A et 2B sont des photographies d'une image ionique d'un même échantillon en analyse classique par la figure 2A et conformément à l'invention pour la figure 2B.

– les figures 3A et 3B sont des photographies analogues d'un autre échantillon.

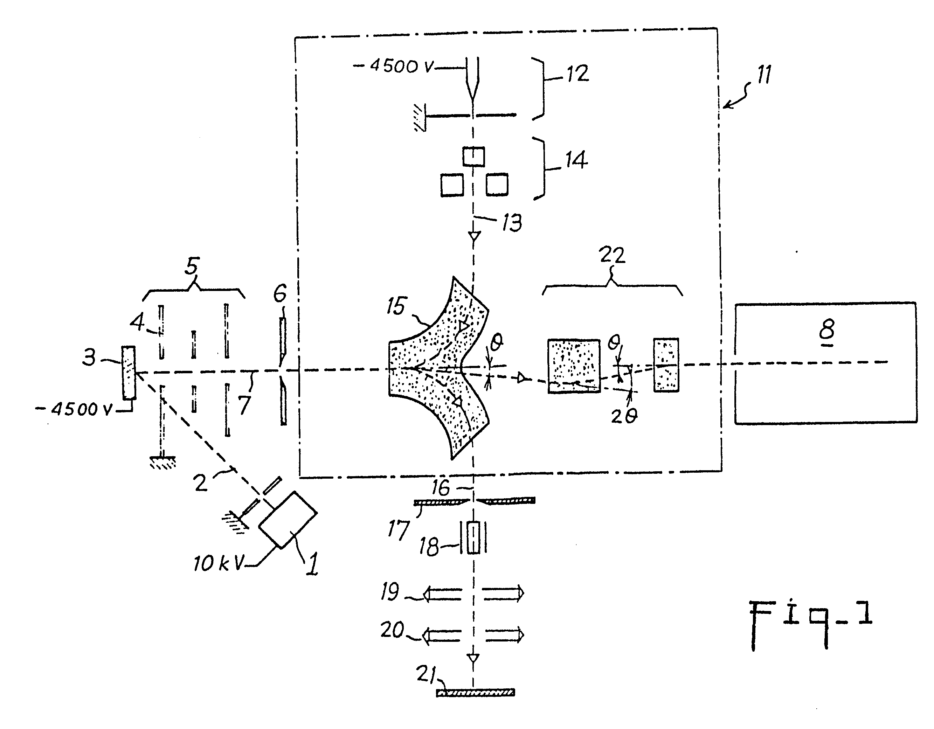

On voit sur la figure 1 une source 1 d'ions primaires portée à un potentiel de 10 kV bombardant un faisceau ionique 2 sur une cible à la surface de l'échantillon 3 porté à un potentiel de –4500 V.

Le faisceau d'ions négatifs secondaires émis par la cible est accéléré par l'électrode extractrice 4, portée à la masse, traverse une optique collectrice 5 puis le diaphragme 6 situé sur le cross-over. Sur le même axe optique 7 est disposé le spectrographe de masse 8 sur lequel ne porte pas l'invention.

Selon l'invention, on interpose entre le diaphragme 6 et le spectrographe 8, le système 11 de suppression des effets de charge. Ce système 11 comprend une source d'électrons 12 située sur un axe 13 coupant l'axe optique général 7 sous un angle, qui, sur la figure, est de 90°. Les électrons sont issus d'un filament porté à un potentiel de –4500 V; ils sont accélérés par une électrode extractrice au potentiel nul, et, traversent un dispositif de centrage classique 14. Ils sont déviés par un prisme magnétique 15 qui les ramène ainsi sur l'axe optique. A la sortie du prisme 15, le faisceau d'électrons passe par le diaphragme 6, cross-over commun au faisceau d'ions et au faisceau d'électrons; ensuite il traverse la lentille à émission 5 et arrive dans la zone située entre l'objet 3 et l'électrode d'extraction 4, zone où règne le champ électrique qui permet d'accélérer les particules négatives émises par la surface. Ce champ électrique freine alors les électrons, leur énergie décroît progressivement et s'annule sensiblement au niveau de la surface. La lentille à émission 5 agit sur les trajectoires électroniques comme elle le fait sur celles des ions négatifs. Il en résulte que les électrons arrivent à la surface avec une composante latérale de la vitesse qui est très faible, leur composante normale à la surface étant nulle ou pratiquement nulle (et ne créant, en tout état de cause, aucune interaction nuisible avec l'échantillon). Les électrons qui ne sont pas utilisés à la neutralisation de la surface de l'échantillon rebroussent chemin, avec des électrons secondaires émis par la surface de l'échantillon (et naturellement avec les ions négatifs).

Le prisme magnétique 15 utilisé pour défléchir de 90° les électrons de décharge est avantageusement double: il défléchit en sens inverse les électrons qui partent de la cible, rendant ainsi possible l'observation de l'image électronique formée à partir des électrons rétrodiffusés ou réfléchis, ou encore celle de l'image obtenue avec les électrons secondaires produits soit par le bombardement ionique primaire, soit par l'impact des électrons incidents. A cet effet, un dispositif analyseur annexe, classique, est prévu sur le chemin du faisceau électronique dévié 16: des lames de sélection 17, un centrage électrostatique 18, une optique post-accélératrice 19, une optique de projection 20, un écran 21.

La présence du prisme 15 sur l'axe optique 7 produit également une légère déviation d'angle Ω de la trajectoire des ions secondaires. Il est donc prévu un système magnétique additionnel 22 pour compenser cette rotation quelle que soit la masse des ions secondaires.

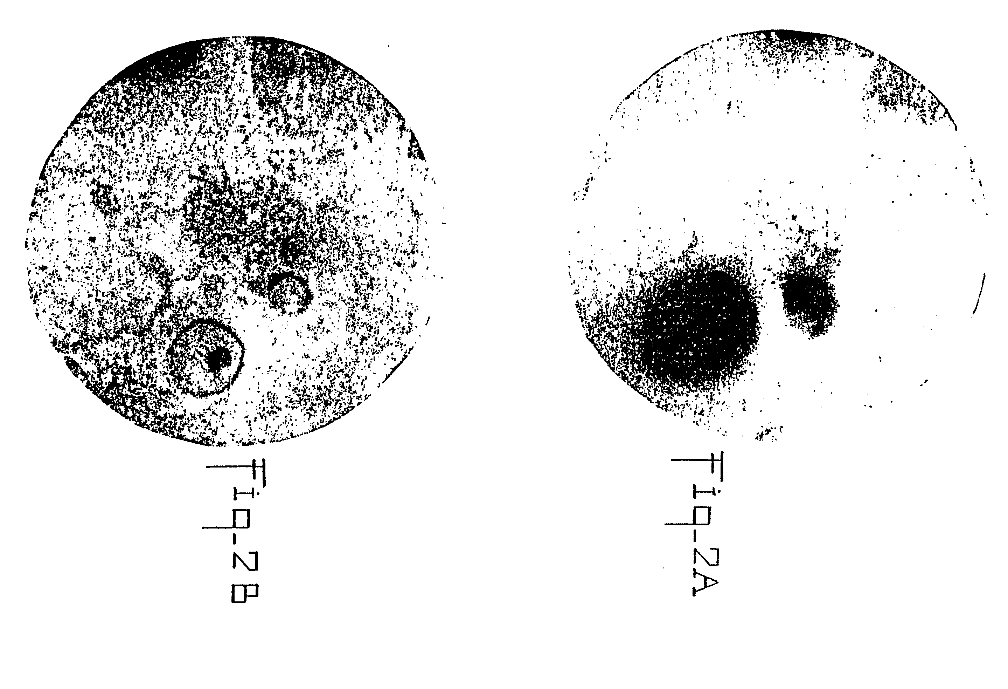

La figure 2A montre une image ionique globale – c'est-à-dire sans filtrage en masse des ions – obtenue par bombardement ionique d'une matrice de fer. Les taches sombres correspondent à des perturbations de l'émission ionique secondaire induites par la présence de petits précipités d'alumine (dimensions respectives: environ 10 et 20 µm) à très faible conductibilité électrique.

La figure 2B montre une image ionique obtenue dans les mêmes conditions de bombardement ionique mais, cette fois, avec intervention d'un faisceau d'électrons de faible énergie (< 10 eV) conformément à l'invention. L'image des précipités d'alumine devient perceptible, renseignant sur les dimensions réelles de ces objets et mettant en évidence pour chacun d'eux l'existence d'une structure interne.

La figure 3A est une image ionique globale obtenue, comme précédemment, par bombardement d'une cible fer-métal riche en précipités d'alumine isolants.

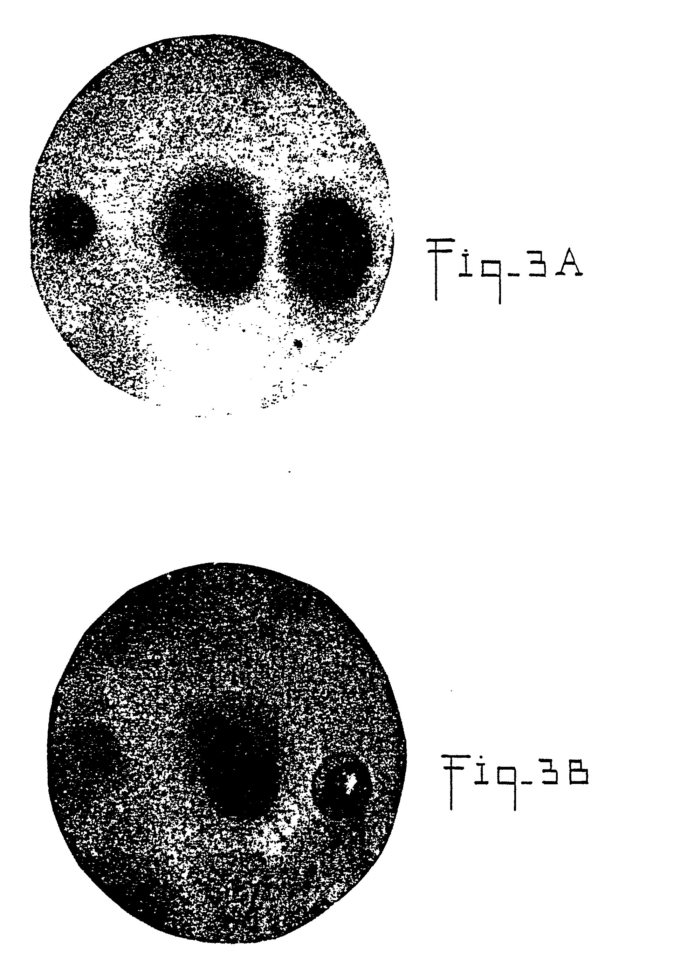

Pour la figure 3B, le faisceau d'électrons à été cette fois localisé sur le précipité d'alumine situé sur la droite de la préparation. L'effet du bombardement électronique se fait également discrètement sentir au niveau du précipité situé au centre de l'image. L'un des mérites de ce procédé de neutralisation des charges électrostatiques est qu'il est autoajustable.

L'adaptation de ce dispositif de décharge des échantillons isolants sur un analyseur ionique classique permet l'analyse, jusqu'ici impossible, d'ions oxygène chargés négativement, émis à partir de matériaux isolants, comme le sont la plupart des composés de l'oxygène, oxides et silicates, et rend possible l'analyse ponctuelle de la composition isotopique de cet élément dans des objets d'intérêt astrophysique: phases minérales clés des météorites, poussières interplanétaires.

Par ailleurs, le procédé conforme à l'invention, qui ne modifie en rien l'aspect physique ou chimique de l'échantillon analysé, autorise toutes sortes d'analyse in situ dont le caractère non-destructif est capital.

## Revendications

1. Procédé d'analyse ionique d'un échantillon isolant (3), porté à un fort potentiel négatif déterminé, du type selon lequel on bombarde une cible sur la surface de l'échantillon à analyser par un faisceau d'ions primaires, caractérisé en ce que les ions négatifs émis par la cible bombardée sont utilisés pour produire une image ionique de l'échantillon, ces ions étant extraits sous champ élevé au moyen d'une électrode extractrice (4) portée au potentiel nul, le procédé étant tel que la neutralisation des charges apparaissant à la surface de l'échantillon est effectuée par un faisceau d'électrons (13) émis par un filament (12), généré en dehors de la zone d'extraction des ions émis par la cible, et accéléré sous un champ égal au champ d'extraction au voisinage de la cible, puis dirigé orthogonalement à la cible avant d'entrer dans le voisinage de la cible où il est ralenti par le même champ élevé de sens contraire, la composante normale de la vitesse s'annulant ainsi juste au niveau de la surface de la cible.

2. Procédé selon la revendication 1, caractérisé en ce que le filament (12) est porté sensiblement au même fort potentiel négatif déterminé, une électrode extractrice portée à la masse permettant l'accélération des électrons.

3. Procédé selon l'une quelconque des revendications 1 ou 2, caractérisé en ce que le faisceau électronique (13) est, après émission, dévié par un prisme magnétique (15) pour être amené en coïncidence avec l'axe optique (7) du faisceau d'ions négatifs émis par la cible.

4. Procédé selon la revendication 3, caractérisé en ce qu'on utilise les électrons partant de la cible dans l'axe optique pour obtenir une image électronique de l'échantillon.

5. Dispositif pour l'analyse ionique d'un échantillon isolant (3) porté à un potentiel négatif déterminé, du type qui comporte une source (1) d'ions de bombardement primaire (2) dirigé sur une cible à la surface de l'échantillon à analyser, et, dans l'axe optique (7) du dispositif, un spectrographe de masse (8), caractérisé en ce que, le spectrographe utilisant des ions négatifs émis par la cible bombardée pour produire une image ionique de l'échantillon, le dispositif comporte également une source (12) portée sensiblement au potentiel de échantillon émettant un faisceau d'électrons (13), et des moyens de déviation (15) pour diriger ce faisceau d'électrons (13) sur la cible, perpendiculairement à la surface bombardée.

6. Dispositif selon la revendication 5, caractérisé en ce que les moyens de déviation consistent en un prisme magnétique (15), et en ce qu'il est prévu un système de compensation magnétique (22) de la déviation par ledit prisme (15) de la trajectoire des ions négatifs émis par la cible.

7. Dispositif selon la revendication 6, caractérisé en ce que le prisme (15) est un prisme magnétique double, déviant les électrons qui partent de la cible dans l'axe optique (7), et en ce qu'il est prévu un analyseur annexe (17, 18, 19, 20, 21) délivrant une image électronique de l'échantillon (3).

**Patentansprüche**

1. Verfahren zur Ionenanalyse einer isolierenden Probe (3), die auf einem bestimmten, starken, negativen Potential gehalten wird, derart, dass ein Zielbereich auf der Oberfläche der zu analysierenden Probe mit einem Primärionenstrahl beschossen wird, dadurch gekennzeichnet, dass die vom beschossenen Zielbereich ausgesandten negativen Ionen verwendet werden, um ein Ionenbild der Probe zu erzeugen, wobei diese Ionen unter Wirkung eines Feldes aus der Probe herausgerissen werden, das mittels einer Extraktionselektrode (4) auf Nullpotential erzeugt wird, wobei das Verfahren derartig ist, dass die Neutralisierung der auf der Probenoberfläche auftretenden Ladungen durch einen Elektronenstrahl (13) ausgeführt wird, der von einem Heizfaden (12) ausgesandt und ausserhalb der Extraktionszone der vom Zielbereich ausgesandten Ionen erzeugt wird, und unter Wirkung eines dem Extraktionsfeld in Nähe des Zielbereichs gleichen Feldes beschleunigt, und dann senkrecht zum Zielbereich gerichtet wird, bevor er die Nähe des Zielbereichs erreicht, wo er vom selben hohen, jedoch in Gegenrichtung aufgebauten Feld verzögert wird, wobei die Normalkomponente der Geschwindigkeit somit genau auf Höhe der Zielbereichsoberfläche verschwindet.

2. Verfahren nach Anspruch 1, dadurch gekennzeichnet, dass der Heizfaden (12) im wesentlichen auf demselben, bestimmten, starken, negativen Potential gehalten wird, und dass eine an die Masse gelegte Extraktionselektrode die Beschleunigung der Elektronen ermöglicht.

3. Verfahren nach einem der Ansprüche 1 oder 2, dadurch gekennzeichnet, dass der Elektronenstrahl (13) nach seiner Aussendung durch ein Magnetprisma (15) abgelenkt wird, um dazu gebracht zu werden, mit der optischen Achse (77) des vom Zielbereich ausgesandten Strahls negativer Ionen zusammenzufallen.

4. Verfahren nach Anspruch 3, dadurch gekennzeichnet, dass die vom Zielbereich in der optischen Achse auftretenden Elektronen verwendet werden, um ein Elektronenbild der Probe zu erhalten.

5. Vorrichtung zur Ionenanalyse einer isolierenden Probe (3), die auf einem bestimmten, negativen Potential gehalten wird, vom Typ mit einer Quelle (1) von Primär-Beschussionen (2), die auf einen Zielbereich auf der Oberfläche der zu analysierenden Probe gerichtet ist, und in der optischen Achse (7) der Vorrichtung einen Massenspektrographen (8) enthält, dadurch gekennzeichnet, dass während der Spektrograph die vom beschossenen Zielbereich ausgesandten negativen Ionen verwendet, um ein Ionenbild der Probe herzustellen, die Vorrichtung gleichermassen eine Quelle (12), die im wesentlichen auf dem Potential der Probe gehalten wird und einen Elektronenstrahl (13) aussendet, und Ablenkmittel (15) enthält, um den Elektronenstrahl auf den Zielbereich, senkrecht zur beschossenen Oberfläche zu richten.

6. Verfahren nach Anspruch 5, dadurch gekennzeichnet, dass die Ablenkmittel aus einem Magnetprisma (15) bestehen und dass ein magnetisches System (22) zum Ausgleich der durch das Prisma (15) erfolgten Ablenkung der Bahn der vom Zielbereich ausgesandten negativen Ionen vorgesehen ist.

7. Vorrichtung nach Anspruch 6, dadurch gekennzeichnet, dass das Prisma (15) ein doppeltes Magnetprisma ist, das die vom Zielbereich in der optischen Achse (7) austretenden Elektronen ablenkt, und dass ein zusätzlicher Analysator (17, 18, 19, 20, 21) vorgesehen ist, der ein Elektronenbild der Probe (3) liefert.

## Claims

1. Method of ion analysis of an insulating specimen (3) connected to a high negative determined potential, of the type wherein a target on the surface of the specimen to be analyzed is bombarded with a primary ion beam, characterized in that the negative ions emitted by the bombarded target are used to produce an ionic image of the specimen, these ions being extracted by a high field by means of an extracting electrode (4) connected to zero potential, the method being such that the neutralization of the charges appearing at the surface of the specimen is performed by an electrode beam (13) emitted by a filament (12), generated outside of the zone of extraction of the ions emitted by the target, and accelerated by a field equal to the extraction field in the neighbourhood of the target, then perpendicularly directed onto the target prior to entering in the neighbourhood of the target where it is slowed down by the same high field of contrary sense, the normal component of the speed vanishing thus right at the level of the target surface.

2. Method according to claim 1, characterized in that the filament (12) is connected substantially to the same high negative determined potential, an extracting electrode connected to ground permitting the acceleration of the electrons.

3. Method according to any of claims 1 or 2, characterized in that the electron beam (13), after emission, is deflected by a magnetic prism (15) in order to become coincident with the optical axis (7) of the beam of negative ions emitted by the target.

4. Method according to claim 3, characterized in that electrons are used which leave the target in the optical axis for obtaining an electronic image of the specimen.

5. Device for the ion analysis of an insulating specimen (3) connected to a negative determined potential, of the type comprising a source (1) of primary bombarding ions (2) directed onto a target at the surface of the specimen to be analyzed, and a mass spectograph (8) in the optical axis (7) of the device, characterized in that the spectograph using negative ions emitted by the bombarded target to produce an ionic image of the specimen, the device further comprises a source (12) substantially connected to the potential of the specimen emitting an electron beam (13) and deflection means (15) for directing this electron beam (13) onto the target perpendicularly to the bombarded surface.

6. Device according to claim 5, characterized in that the deflection means consist in a magnetic prism (15) and in that a magnetic compensation system (22) is provided which compensates for the deflection of the path of the negative ions emitted by the target as produced by the prism (15).

7. Device according to claim 6, characterized in that the prism (15) is a double magnetic prism deflecting the electrons leaving the target in the optical axis (7) and in that an auxiliary analyzer (17, 18, 19, 20, 21) is provided which supplies an electronic image of the specimen (3).

Fig-1

0 114 765

Fig-2A

Fig-2B

9

Fig-3A

Fig-3B